# EUROPEAN PATENT SPECIFICATION

(11) **EP 2 005 474 B1**
(45) Date of publication and mention of the grant of the patent: **04.09.2019**
(21) Application number: 07727918.0
(22) Date of filing: 10.04.2007
(51) Int. Cl.: H01L 27/142, H01L 31/042, H01L 31/05

(54) **SOLAR MODULE**
SOLARMODUL
MODULE SOLAIRE

(30) Priority: 13.04.2006 EP 06112588; 13.04.2006 EP 06112597
(43) Date of publication of application: 24.12.2008
(73) Proprietor: (CNBM) Bengbu Design & Research Institute for Glass Industry Co., Ltd., Bengbu (CN)
(72) Inventor: KARG, Franz, 81671 Munchen (DE); VOGT, Helmut, Siemens Gelände Gebäude 31, Raum 31.746 81739 München (DE)
(74) Representative: Gebauer, Dieter Edmund
(86) International application number: PCT/EP2007/053450
(87) International publication number: WO 2007/118814

(56) References cited:
- EP-A- 1 079 441
- EP-A- 1 258 925

## Description

The present invention relates to a solar module.

A solar module has to withstand a wide variety of operating conditions without resulting in permanent electrical, mechanical, or optical damage. One example of particular interest for the present specification is partial shading of parts of the module or individual cells comprised in the module. Partial shading is covered in test procedures such as the so-called "hot-spot endurance test" in IEC 61215 or 61646. Shading of one or several individual solar cells in a module consisting of a larger number of series connected solar cells may lead to reverse biasing of the shaded cell(s). As a high reverse bias of a semiconductor diode (such as a solar cell) may lead to irreversible damage, the maximum reverse bias voltage applied under conditions of partial shading must be limited. For this reason, bypass diodes may be provided, which are typically wired anti-parallel to a limited number of solar cells.

Such bypass diodes traditionally are mounted and wired in a separate junction box that in many cases also serves to connect the module to external power cables. Integrated bypass diodes have also been proposed, which could reduce the need for a separate junction box.

US Pat. No. 6,288,323 to Hayashi et al describes a thin film photoelectric conversion module, including a substrate and a plurality of thin film photoelectric conversion cells formed on the substrate and connected to each other in series to form a series-connected array. The conversion cells consist of a transparent front surface electrode layer, a thin film photoelectric conversion unit, and a metal back surface electrode layer. The series-connected array consists of four sub-arrays that are connected in series, whereby each of the four sub-arrays comprises a number of cells connected in series. Four bypass diodes are formed in the form of a thin film on the substrate, each having a construction similar to that of the photoelectric conversion cells.

One of the bypass diodes in US Pat. '323 is connected in parallel to one of the sub-arrays of photoelectric conversion cells, in a forward direction relative to the power generating direction of that sub-array. The transparent front surface electrode layer of the bypass diode is electrically connected to the bus bar or to the metal back surface electrode layer adjacent to the bus bar. The metal back surface electrode layer of that bypass diode is electrically connected to the transparent front surface electrode layer of the cell, of the sub-array, which is positioned adjacent to the adjoining sub-array, or to the metal back electrode layer of the cell of the adjoining sub-array, which positioned adjacent to the sub-array.

Hayashi et *al* do not describe how such connections between electrode layers of a bypass diode and electrode layers of a photoelectric conversion cell are established.

Moreover, an electrical connection between the metal back surface electrode layer of a bypass diode and the transparent front surface electrode layer of a photoelectric conversion cell, as proposed in US. Pat. '323, has a drawback that parts of the cells that are located relatively far away from the bypass diode, encounter a relative long electrical path to the bypass diode through the front surface electrode layer, which is generally relatively weakly conducting. As a result, a current feeding the bypass diode experiences a relatively high electric resistance connection with the back electrode of their adjacent bypass diode and thereby causes a reverse voltage across the solar cell. In accordance with the invention, there is provided a solar module according to claim 1 comprising first and second bus bars and a common substrate supporting a rectifying diode sheet, the rectifying diode sheet comprising at least a back electrode layer, a front electrode layer, and an absorber layer located between the back electrode layer and the front electrode layer, wherein the rectifying diode sheet is divided in first and second sheet parts, said first sheet part comprising a first string of one or more series connected solar cells each having front and back electrodes formed in the front and back electrode layers, which first string is series connected to the first and second bus bars, and said second sheet part comprising a second string of one or more series connected bypass diodes each having front and back electrodes formed in the front and back electrode layers, which second string is connected in an anti-parallel configuration with the first string via the first and second bus bars. It is remarked that the back electrode layer of the rectifying diode sheet may be located between the substrate and the absorber layer, whereby the front electrode layer faces the side of the absorber layer that faces away from the substrate, or it may be located on the side of the absorber layer facing away from the substrate, whereby the front electrode layer is located between the substrate and the absorber layer. The first case may be referred to as "substrate technology design", the second case as "superstrate technology design", whereby the light is generally received through the substrate.

The invention will be described hereinafter in more detail by way of example and with reference to the accompanying drawings, wherein
Fig. 1a schematically shows one example of an integrated electric series connection in cross section along line X-X as shown in Fig. 1b;
Fig. 1b is a collage showing a schematic top view of the integrated electric series connection of Fig. la and schematic representations of patterning lines P1, P2, and P3;
Fig. 1c is a schematic representation of a combination of P1-P2-P3 patterning lines as used in the electric circuit diagrams of Figs. 3b, 4b, 5b, 6b 7b, and 8b;
Fig. 1d is a schematic representation of a combination of P3-P2-P1 patterning lines as used in the electric circuit diagrams of Figs. 3b, 4b, 5b, 6b, 7b, and 8b;
Fig. 2a schematically shows another example of an integrated electric series connection in cross section along line Y-Y as shown in Fig. 2b;
Fig. 2b is a collage showing a schematic top view of the example of Fig. 2a and schematic representations of patterning lines P1, P2, and P3;
Fig. 3a schematically shows a top view of a solar module in accordance with an embodiment of the invention;
Fig. 3b schematically shows an electric circuit diagram corresponding to the diode network of the solar module of Fig. 3a;
Fig. 4a schematically shows a top view of a solar module which is not part of the invention;
Fig. 4b schematically shows the electric circuit diagram corresponding to the diode network of the solar module of Fig. 4a;
Fig. 5a schematically shows a top view of a solar module in accordance with a further embodiment of the invention;
Fig. 5b schematically shows the electric circuit diagram corresponding to the diode network of the solar module of Fig. 5a;
Fig. 6 schematically shows a top view of a solar module in accordance with a further embodiment of the invetion;
Fig. 7a schematically shows a top view of a solar module in accordance with a further embodiment of the invention;
Fig. 7b schematically shows the electric circuit diagram corresponding to the diode network of the solar module of Fig. 7a;
Fig. 8a schematically shows a top view of a solar module which is not part of the invention;
Fig. 8b schematically shows the electric circuit diagram corresponding to the diode network of the solar module of Fig. 8a;
Fig. 9a schematically shows a top view of a solar module which is not part of the invention;
Fig. 9b schematically shows the electric circuit diagram corresponding to the diode network of the solar module of Fig. 9a; and
Fig. 10 (parts a to d) shows schematic top views of various general solar module lay-outs employing one or more of the embodiments of the invention.

In the Figures like reference numerals relate to like components.

Amongst advantages of the presently disclosed solar modules is that the production of the one or more bypass diodes on the module need not incur additional processing steps since they may be formed out of the same rectifying diode sheet as the one or more solar cells. Moreover, subsequent processing steps used for producing the one or more solar cells may be also applied for producing the one or more bypass diodes.

Since, according to the invention, the string of one or more series connected solar cells and the string of one or more series connected bypass diodes are connected in an anti-parallel configuration with the first string via the first and second bus bars, the connection of the solar cell with the bypass diode can thus benefit from the electrical conductivity of the bus bar, which may be chosen higher than that of the front electrode layer. The electric connection of the string of one or more solar cells to the bus bars does not require conduction through the front electrode layer to any greater extent than what is anyway required under normal operating conditions for the generated current to reach the bus bars.

This may cause less overheating of the solar cell and/or more effectively limit the maximum reverse bias voltage a solar cell may be exposed to, when during the generation of electric current the bypass diode needs to be conducting some of the current due to shading of the module or parts thereof.

The first string comprises a first solar cell sub-string and a second solar cell sub-string, while the second string comprises a first bypass diode sub-string and a second bypass diode sub-string, wherein the first solar cell sub-string comprises one or more solar cells and the second solar cell sub-string comprises one or more solar cells, whereby the first and second solar cell sub-strings are series connected, and whereby the first bypass diode sub-string comprises one or more bypass diodes and the second bypass diode sub-string comprises one or more bypass diodes, whereby the first bypass diode and second bypass diode sub-strings are series connected, whereby in addition to the first string and second string being connected in anti-parallel configuration via the first and second bus bars, the first solar cell sub-string is connected in anti-parallel configuration with the first bypass diode sub-string and the second solar cell sub-string is connected in anti-parallel configuration with the second bypass diode sub-string.

The front electrode of the one solar cell in the first solar cell sub-string that is series connected to the back electrode of the one solar cell in the second solar cell sub-string is also connected to the back electrode of the one bypass diode in the first bypass diode sub-string that is series connected with the front electrode of the one bypass diode in the second bypass diode sub-string.

The claimed invention takes full advantage of the back electrode layer for connecting the solar cell sub-strings to the bypass diode sub-strings, including there where there is no bus bar available.

It is remarked that US Pat. No. 6,274,804 to Psyk et al also describes a thin-film solar module consisting of solar cells that are series connected along side of each other on a common substrate, whereby a number of diodes are disposed anti-parallel and adjacent to the solar cells. However, each diode is connected in the reverse direction with the adjacent solar cell in at least two overlap zones, whereby the front electrode layer of the diode is directly connected with the back electrode layer of the solar cell in such an overlap zone, and the back electrode layer of the diode is directly connected with the front electrode layer of the solar cell in at least one other such overlap zone. Hence, Psyk also suffers from the drawback that parts of the cells that are located relatively far away from the bypass diode and thus encounter a relative long electrical path to the bypass diode through the front surface electrode layer.

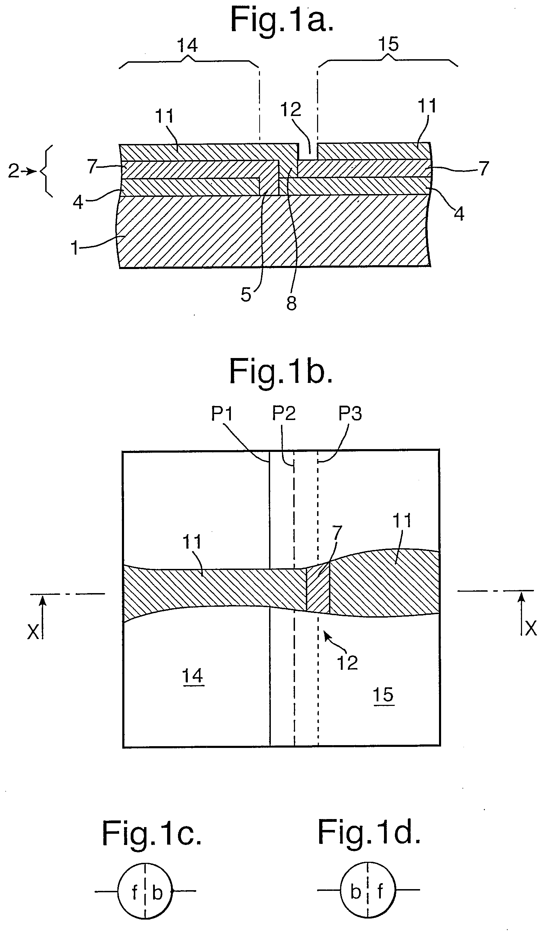

Referring now to Fig. 1a there is shown a cross sectional view of one possible embodiment of an integrated electric series connection in a thin-film rectifying diode structure, of which in Fig. 1b a top view is depicted.

The thin-film rectifying diode structure, as depicted in Figs. 1a and b, comprises a substrate 1 that supports a rectifying diode sheet 2. The rectifying diode sheet comprises at least a back electrode layer 4, a front electrode layer 11, and an absorber layer 7 located between the back electrode layer 4 and the front electrode layer 11. The back electrode layer 4 has an electrical interruption formed therein at 5, electrically separating the region on the left hand side of interruption 5 from the adjacent region on the right hand side of interruption 5. Such an interruption is in the art also referred to as a patterning line.

In the present specification, an electrical interruption in at least the back electrode layer will be referred to as a P1 patterning line or a P1 line. The patterning line may be filled with another material. In the example as shown in Fig. 1, the electrical interruption 5 has been filled with material of the absorber layer 7.

Similarly as described above for the back electrode layer 4, the absorber layer 7 has an electrical interruption formed therein at 8, in the form of a hole protruding through the entire layer and exposing the back contact layer 4. The electrical interruption 8 has here been filled with material of the front electrode layer 11.

Again similarly, the front electrode layer 11 has an electrical interruption formed therein at 12, in the form of a hole protruding through the entire layer 11. The hole may this time be filled with an insulating material that may optionally be applied to the structure as a cover layer (not shown). An electrical interruption formed in at least the front electrode layer is for the purpose of this specification referred to as a patterning line P3.

In the example of Figs. 1a and b, both the interruptions 8 and 12 have predetermined locations relative to the electrical interruption 5 formed in the back electrode layer 4. The rectifying diode sheet 2 is thus divided in separate diodes 14 and 15, by means of the patterning lines 5, 8, and 12.

The region of the front electrode layer 11 that belongs to region 14 is electrically connected with an adjacent region defined in the back electrode layer 4 that belongs to region 15. For the purpose of this specification, a conductive electrical connection between the front electrode layer 11 and the back electrode layer 4 is referred to as a patterning line P2.

In the embodiment as shown in Figs. 1a and b the P2 electrical connection is formed by material of the front electrode layer 11 filling the hole 8 and thus contacting the exposed back electrode layer 14. As the front electrode layer of one region is thus electrically connected with the back electrode layer of a region that has opposite polarity, an integrated electric series connection has been formed.

Such an integrated electric series connection comprising patterning lines interrupting the individual layers may be formed by various methods and principles. However, the underlying concept is that the first patterning line, P1, corresponds to a division of the back electrode layer into neighbouring parts, the second patterning line, P2, corresponds to an electrical connection between the electrode layer farthest removed from the substrate a part of the electrode layer nearest to the substrate, and the third patterning line P3 corresponds to a separation into neighbouring parts of at least the electrode layer located on the other side of the absorber layer relative to the back electrode.

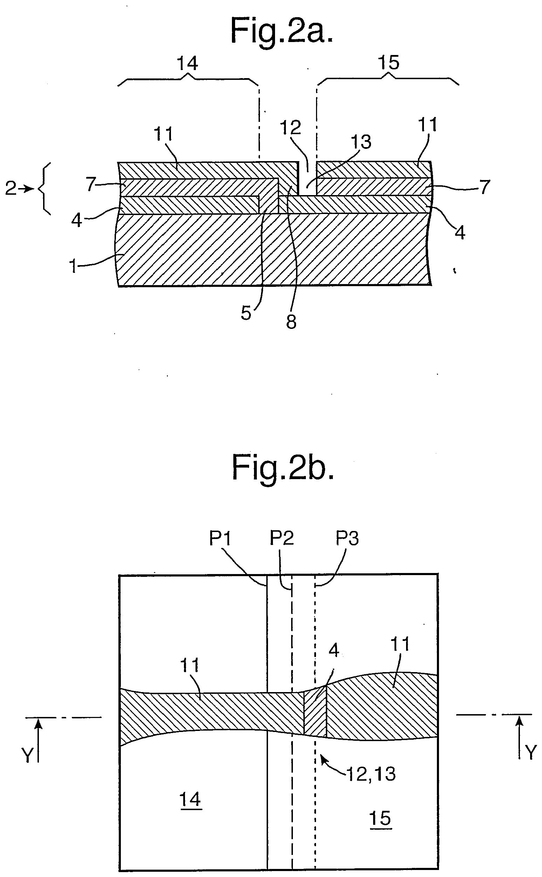

The separation into neighbouring parts of at least the front electrode layer located on the other side of the absorber layer relative to the back electrode may also include separating of the absorber layer 7 in part or in full, such as is shown in Fig. 2a at 13.

When also the absorber layer 7 has been fully separated, a hole is formed exposing the electrode layer that is nearest to the substrate, as shown at 4, in Fig. 2b. An advantage of separating also the absorber layer is that a better electrical separation is achieved in the front electrode layer across a P3 patterning line.

Likewise, a P1 patterning line may cut through more than just the back electrode layer.

The acronyms P1, P2, and P3 will be used hereinafter in that generic sense, and will be graphically depicted in the way as will now be illustrated in Fig. 1b. Fig. 1b shows P1 as a solid continuous line to indicate the middle of interruption 5. P2 is shown as a dashed line, and P3 as a dotted line. Fig. 1b represents a collage, wherein in the middle part a top view is depicted of the structure of Fig. la. The top view shows the front electrode layer 11, and the absorber layer 7 where it is exposed at 12. Thus reading from left to right, a sequence of P1-P2-P3 lines denotes an electrical connecting from the front electrode of the left-hand region 14 to the back electrode of the right-hand region 15. Such an electrical series connection from front electrode to back electrode will hereinafter also be schematically represented with an (f|b) symbol as shown in Fig. lc.

The opposite sequence, whereby reading from left to right the back electrode is connected to the front electrode, will be represented by a (b|f) symbol as shown in Fig. 1d.

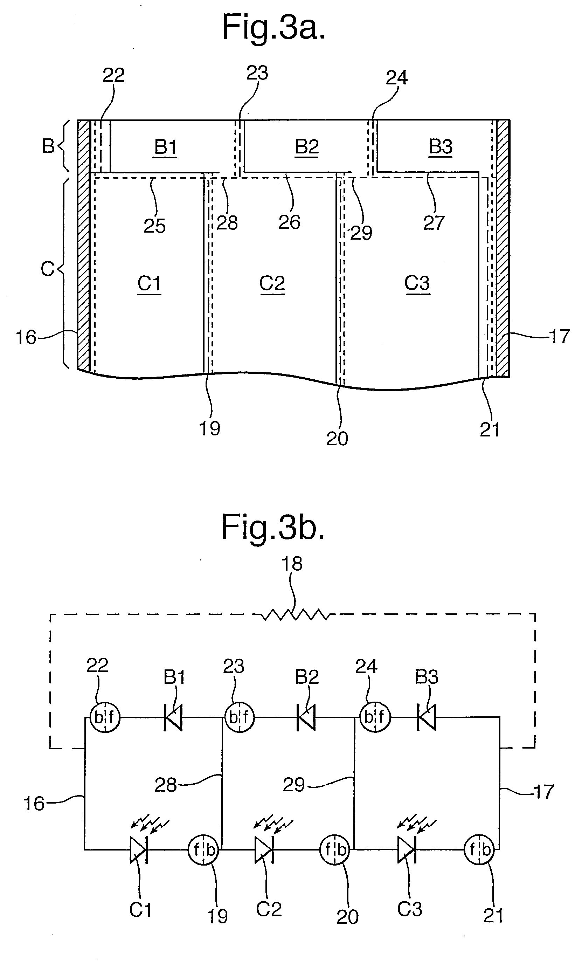

Reference is now made to Fig. 3a, wherein a schematic top view is shown of a section of a solar module in an embodiment, comprising a common substrate supporting the rectifying diode sheet 2, a light-receiving front side and a back side facing away from the front side. The solar module is depicted including graphical representations of P1, P2, and P3. In Fig. 3b, showing the corresponding electric circuit diagram, the symbols (f|b) and (b|f) have been used to indicate a transition from conduction through the back electrode layer to conduction through the front electrode layer, as set out above with reference to Figs. 1a-d and 2a-b.

The hatched areas 16 and 17 on respectively the left and right hand sides of the module of Fig. 3a represent first and second of so-called bus bars. Bus bars may typically comprise conductive metallic ribbons electrically connected to the back electrode layer or the front electrode layer. The latter may be established either by direct contact between the bus bar and the front electrode layer or, such as is the case in Fig. 3a, via an electrical connection with the back electrode layer.

The side on which the front electrode layer is provided, is defined to correspond to the light-receiving side of the solar module. The back electrode layer, which needs not be translucent to light, has a higher electrical conductivity than the front electrode layer.

The rectifying diode sheet is divided in a first sheet part C and a second sheet part B. To keep things simple, the principle of this embodiment will be set out assuming that the first sheet part C comprises a first string with first, second, and third solar cells C1, C2, and C3, and that the second sheet part B comprises a second string with first, second, and third bypass diodes B1, B2, and B3. It will be understood that, instead of three, other numbers may be employed regarding either the solar cells, the bypass diodes or both.

The area covered by each of the solar cells C1, C2, C3 has an elongated shape having a long side and a short side that is shorter than the long side. The second sheet part B is located side-by-side adjacent to the short side of the solar cells. In the shown embodiments the elongated shape defines a rectangle.

Although not visible in Fig. 3a, the solar cells C1, C2, and C3 each have front and back electrodes formed in the front and back electrode layers 11 and 4 as shown in Figs. 1a and 2a. Likewise, the bypass diodes B1, B2, and B3 each have front and back electrodes formed in the front and back electrode layers. The first sheet part C also comprises first, second, and third electrical integrated series connections 19, 20, and 21, along the long sides of the solar cells. Such an electrical integrated series connection extends the solar cell's front electrode and a respective adjacent region defined in the back electrode layer. The respective adjacent regions to which the front electrodes of solar cells C1 and C2 connect, are formed by the back electrodes of solar cells C2 and C3. The defined adjacent region to which the front electrode of solar cell C3 connects is formed by bus bar 17, or at least by the area where the bus bar connects to the back electrode layer.

The solar module is connectable to an external electric load, schematically depicted in Fig. 3b at 18, via the bus bars. The solar cells C1, C2, C3 in the set are series connected between the bus bars, thereby forming the first string of series connected solar cells. Thus, with the described electrical series connections connecting the front electrode of each solar cell to the back electrode of an adjacent region, the solar module is connectable to the electric load via the back electrodes of each of the solar cells on the side of one polarity (anode or cathode) and the back electrode connected to the right-hand bus bar 17 on the other side of opposite polarity (cathode or anode).

Describing the solar module in more detail, starting from the bus bar 16 on the left in the first sheet part C, and reading to the right, one encounters: bus bar 16, a P3 line; solar cell C1, the bus bar 16 being connected to the back electrode of solar cell C1 underneath the P3 line, an electrical series connection formed by sequence P1-P2-P3 at 19; solar cell C2; an electrical series connection formed by sequence P1-P2-P3 at 20; solar cell C3; an electric series connection formed by sequence P1-P2-P3 at 21; and finally bus bar 17.

Starting from the bus bar 16 on the left in the second sheet part B, and reading to the right, one encounters: bus bar 16, an electrical series connection formed by sequence P3-P2-P1 at 22; bypass diode B1; an electrical series connection formed by sequence P3-P2-P1 at 23; bypass diode B2; an electrical series connection formed by sequence P3-P2-P1 at 24; bypass diode B3; a P3 line; and finally bus bar 17.

The rectifying diode sheet is divided in first and second sheet parts C and B by means of electrical interruptions formed in the front and/or back electrode layer, as depicted by P1 and/or P3 lines at 25, 26, 27, 28, and 29. At 25, 26, and 27 both a P1 and a P3 line is provided. Lines P1 and P3 have been depicted as being displaced relative to each other, but may also be overlapping each other. At 28, only a P3 line is provided separating the front electrode of solar cell C1 from the front electrode of bypass diode B1, but not the back electrodes. The same is the case at 29, in respect of solar cell C3 and bypass diode B2.

Series connections exist between the bypass diodes B1, B2, and B3 at 23 and 24 in the second string, that are separate from the series connections between the solar cells C1, C2, and C3 at 19 and 20 in the first string.

The second string (comprising the bypass diodes) is connected in an anti-parallel configuration with the first string (comprising the solar cells) via the first, left hand bus bar 16, and the second, right hand bus bar 17.

With reference to both Figs. 3a and 3b, the corresponding electrical circuit is explained as follows. The front electrode of solar cell C2 (for instance) is connected over the P2 line at 20 to the back electrode of its neighbouring solar cell C3. The back electrode of solar cell C3 is connected to the back electrode of bypass diode B2 at 29 because the back electrode layer continues underneath P3. Thus, the front electrode of solar cell C2 in effect makes electrical contact with the back electrode of bypass diode B2 via the back electrode of solar cell C3. The front electrode of bypass diode B2 is electrically connected, via P2 at 23, to the back electrode of its neighbouring bypass diode B1. The latter is in electrical contact with the back electrode of solar cell C2 at 28. The result is that the back electrode of solar cell C2 is electrically connected to the front electrode of bypass diode B2.

Summarising, the bypass diode B2 is electrically circuited in an anti-parallel configuration with solar cell C2.

Likewise, the bypass diode B1 is electrically circuited in an anti-parallel configuration with solar cell C1 and bypass diode B3 is electrically circuited in an anti-parallel configuration with solar cell C3.

As stated above, there is an electric series connection between each of the solar cells C1, C2, and C3, whereas each of the bypass diodes B1, B2, B3 are in a separate string with series connections. Using the diagram of Fig. 3b, it can easily be verified that it is not necessary to provide individual electrical connections between, for instance Cl-Bl as well as C2-B2, in order for B1 and B2 to be configured anti-parallel to respectively C1 and C2. Instead, connection 28, through the back electrode layer, is shared. That is because connection 28 connects to both the back electrode of B1 and the front electrode of B2 (via the integrated series connection 23) and to both the back electrode of C2 and the front electrode of C1 (via the separate integrated series connection 19). Thus, electrical connections between the first and second sheet parts may be shared and preferably established via the back electrode layer, thereby taking advantage of the lower resistivity of the back electrode layer compared to that of the front electrode layer.

In operation, the module of Figs. 3a and b works as follows. An electric load 18 is connected to bus bars 16 and 17 in order to allow for a current to flow. In operating conditions whereby each of the solar cells C1, C2, C3 is sufficiently exposed to incoming light, they generate the current which is directed from right to left, from bus bar 17 to bus bar 16, and back to bus bar 17 through the electric load. When, for example, solar cell C1 is shaded, the diode forming the solar cell C1 is in blocking direction relative to the direction of the photocurrent from the other cells within the first string. The current generated by the remaining solar cells will thus be conducted predominantly through a highly conductive channel in the back electrode (formed in this case by the back electrode of solar cell C2) through bypass diode B1. The current does not need to pass through the front electrode of solar cell C1 to reach its bypass diode.

Likewise, it is seen that both the front electrode and the back electrode of distant parts of solar cell C2 relative to the bypass diode B2, or those of solar cell C3 relative to bypass diode B3, are connected to the respective bypass diode via the back electrode layer. The current collected from both the back and front electrode of the solar cells under full or partial shading conditions is thus conducted to bypass diodes in the string of bypass diodes predominantly via the bus bars or the higher conductive back electrode layer channels.

It is remarked that the front electrode of solar cell C3, being the first solar cell in the string of solar cells, is connected to bypass diode B3 via bus bar 17 since the bus bar 17 is electrically connected to the back electrode layer. In an embodiment, the bus bar 17 may be directly connected to the C3 solar cell's front electrode.

It should be understood that, instead of C1, C2, and C3 being formed of individual solar cells, these may also be formed by solar cell sub-strings comprising series connected individual solar cells. Likewise, the bypass diodes B1, B2, B3 may each represent a bypass diode sub-string of series connected bypass diodes. This is also the case regarding the embodiments shown and described below.

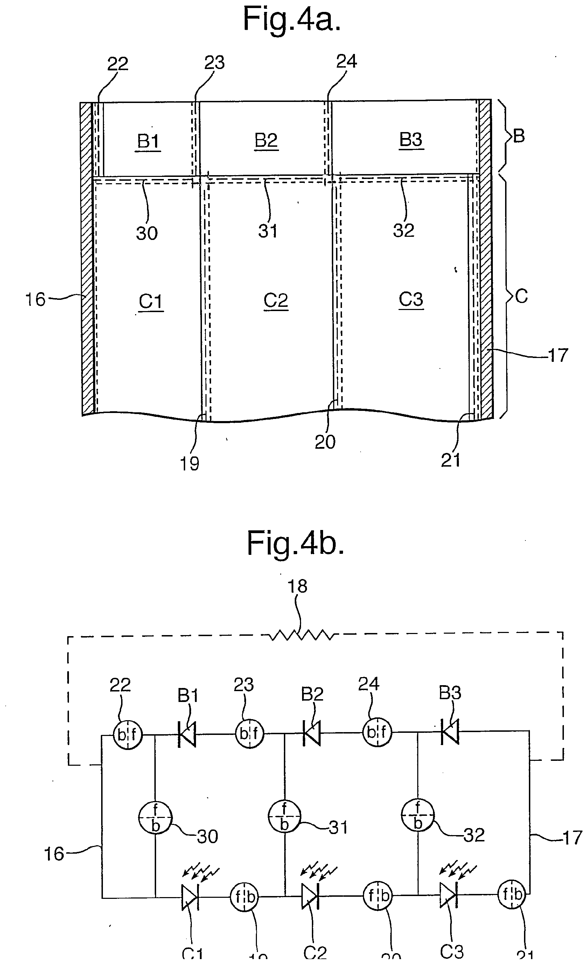

Referring now to Fig. 4a, a solar module, which is not part of the invention, is shown in a similar way as in Fig. 3a above. In this embodiment, the rectifying diode sheet is divided in first sheet part C and second sheet part B using P3, P2, and P1 lines at 30, 31, and 32 (reading from the first sheet part C to the second sheet part B).

The first sheet part C comprises solar cells C1, C2, and C3, and electric series connections at 19, 20, and 21, between the bus bars 16 and 17 and the solar cells C1, C2, C3.

The second sheet part B comprises bypass diodes B1, B2, B3 and separate electric series connections at 22, 23, and 24, between the bus bars 16 and 17 and the bypassdiodes B1, B2, B3. The bypass diodes are arranged essentially the same as in the embodiment shown in Fig. 3a.

The back electrode of solar cell C1 is connected to the front electrode of bypass diode B1 via the P3-P2-P1 lines at 30. In the same way, the back electrodes of solar cells C2 and C3 are respectively connected with the front electrodes of bypass diodes B2 and B3 at respectively 31 and 32.

Referring now also to Fig. 4b, the electrical circuit and the protection function of this embodiment can be described as follows. The front electrode of solar cell C2 is connected to the back electrode of solar cell C3 via P2 at 20. A second, orthogonally arranged P2 line connects the back electrode of solar cell C3 to the front electrode of bypass diode B3 at 32. A third P2 line, at 24, connects the front electrode of bypass diode B3 with the back electrode of bypass diode B2. The front electrode of bypass diode B2 is connected via another P2 line with the back electrode of solar cell C2 at 31.

The result is that bypass diode B2 is electrically connected in an anti-parallel configuration with solar cell C2, whereby the front electrode of solar cell C2 is connected with the back electrode of bypass diode B2 via the adjacent region of the back electrode layer formed by the back electrode of solar cell C3, and the back electrode of the same solar cell C2 is connected to the front electrode of the same bypass diode B2.

The bypass diode B1 is electrically connected in an anti-parallel configuration with solar cell C1 and bypass diode B3 is electrically connected in an anti-parallel configuration with solar cell C3. In the case of solar cell C3, the relevant adjacent region in the back electrode layer to which C3's front electrode connects, is formed by bus bar 17 or a region between the P3 line at 21 and the bus bar 17.

As can most easily be seen in Fig. 4b, the P2 line at 30 is optional as the back electrode of solar cell C1 is already connected to the front electrode of bypass diode B1 via bus bar 16 and the P2 line at 22. Alternatively, when the P2 line at 30 is in place, the P2 line at 22 may be considered optional.

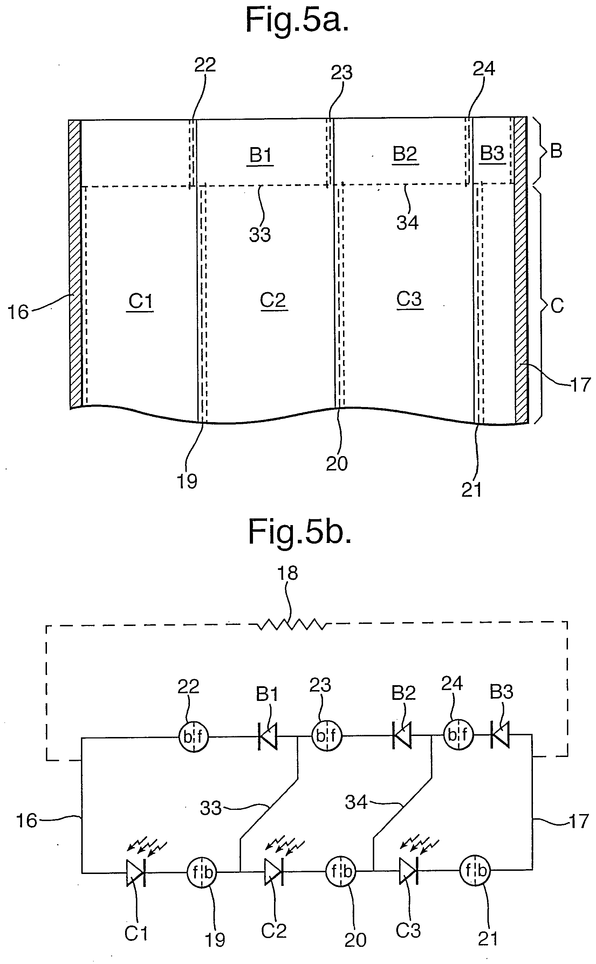

Referring now to Fig. 5a, a further embodiment of the invention is shown in a similar way as above. In this embodiment, the first sheet part C comprising the solar cells C1, C2, C3 is divided from the second sheet part B by a P3 line comprising sections 33, 34. Each solar cell has its own bypass diode, but in this embodiment bypass diode of a particular solar cell is side-by-side to its neighbouring solar cell so that it seems shifted by one cell-width.

The electric series connections at 19, 20, and 21, between the bus bars 16 and 17 and solar cells C1, C2, C3 is again shown. However, there is some more distance left between the electric series connection as 21 and the right hand bus bar 17 than before. This allows for a region to become available for accommodating bypass diode B3. The bypass diodes are also series connected as in the first and second embodiments, but there is one solar cell width distance between the left hand bus bar 16 and the P2 line at 22 that connects the front electrode of bypass diode B1 with the bus bar 16. Solar cell C2 is separated from bypass diode B1 at 33 via the mentioned P3 line. The same holds for the separation between C3 and B2.

The circuit equivalent is explained with reference to both Figs. 5a and 5b. As in the previous embodiments, the front electrode of solar cell C2 is electrically series connected to the back electrode of solar cell C3 via the P2 line at 20. The back electrode of solar cell C3 is in electrical contact with the back electrode of bypass diode B2 as the electrical interruption at 34 is only in the front electrode and not the back electrode layer. The front electrode of bypass diode B2 is in contact with the back electrode of bypass diode B1 via series connection P2 at 23. The latter is directly connected with the back electrode of solar cell C2 at 33 (in the same way as B2 connects to C3).

The result is that the front electrode of solar cell C2 is connected to the back electrode of bypass diode B2 via the back electrode of solar cell C3, which thus forms the relevant adjacent region. And, the back electrode of solar cell C2 is connected to the front electrode of bypass diode B2. Thus, bypass diode B2 is electrically circuited in an anti-parallel configuration with solar cell C2.

Likewise, the bypass diode B1 is electrically circuited in an anti-parallel configuration with solar cell C1 and bypass diode B3 is electrically circuited in an anti-parallel configuration with solar cell C3.

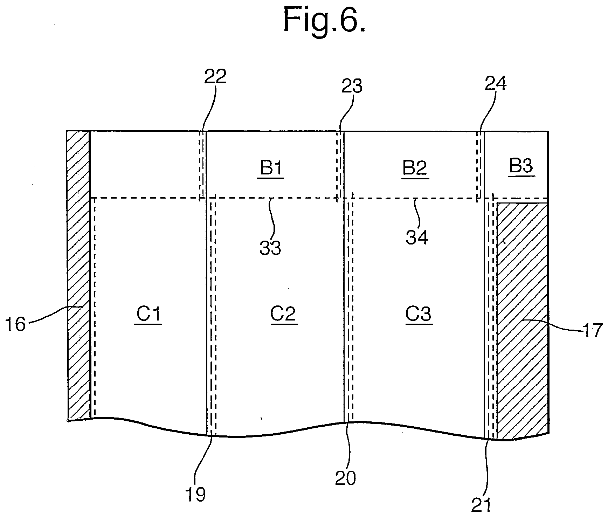

Fig. 6 represents a further embodiment of the invention which is very similar to the embodiment of Fig. 5a as described above.

Instead of allowing some more distance between the electric series connection as 21 and the right hand bus bar 17 than before, the bus bar 17 does not extend to the second sheet part B comprising the bypass diodes.

Thereby, more space is available for the bypass diode B3. The back electrode of bypass diode B3 does connect to the bus bar 17, because there is only a P3 line provided between them.

It is noted that in the embodiments as depicted in Figs. 5 and 6, all the P1 lines (in 19, 20, 21) exclusively extend parallel along one direction, here along the long sides of the solar cells C1, C2, C3 and/or parallel to the bus bars 16, 17 and/or transverse to the one or more electrical interruptions that define the separation between the first (C) and second (B) sheet parts of the rectifying diode sheet. This may be beneficial during production of the solar modules, since the transverse P1 lines perpendicular to the longitudinal patterning direction can be avoided in the process of establishing the patterning lines such as for instance by laser scribing.

Moreover, relative to the embodiment as shown in Fig. 3a, the electrical resistance between the solar cells and the bypass diodes is lower because the back electrode layers of the solar cells make electrical connection with the back electrode layers of the bypass diodes over substantially the full available width of the solar cells. In Fig. 3a, however, contact between the back electrode layers of the solar cells and the bypass diodes is limited to sections underneath the P3 lines at 28 and 29 because P1 lines interrupt the remaining part of the width available width in the solar cells at 25, 26, 27.

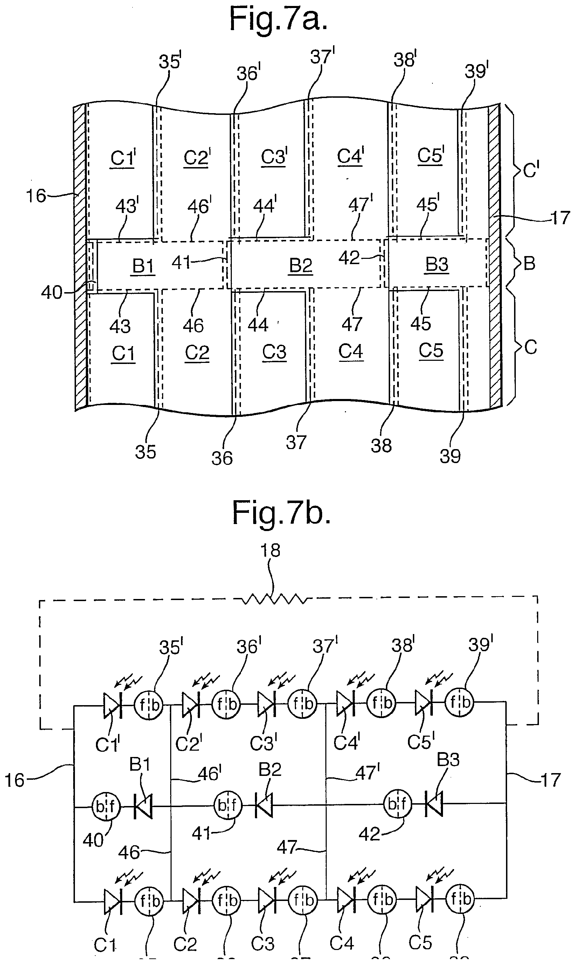

Reference is now made to Fig. 7 wherein still another embodiment is illustrated. There are two notable differences between this embodiment and the previously shown ones. Firstly, the bypass diodes here each bridge a plurality of solar cells. Secondly, the second sheet part B, comprising the bypass diodes, has a central location whereby a first sheet part C comprising solar cells is neighbouring to second sheet part B on one side and a third sheet part C' comprising more solar cells is neighbouring to the second sheet part B comprising the bypass diodes on another side.

The first sheet part C comprises a first set forming a first string of solar cells C1, C2, C3, C4, and C5 series connected between bus bars 16 and 17 over P2 lines at 35, 36, 37, 38, and 39. The first string is divided in three solar cell sub-strings, one comprise ng solar cell C1, one comprising solar cells C2 and C3, and one comprising solar cells C4 and C5. Parallel to the first string of solar cells, a second set forming a third string of series connected solar cells C1', C2', C3', C4', and C5' is arranged connecting to the bus bars 16 and 17. The second set is comprised in the third sheet part C'. The second set of solar cells is series connected between the bus bars 16 and 17 via P2 lines at 35', 36', 37', 38', and 39'.

Like in, for instance, the embodiment of Fig. 3, the second string of bypass diodes B1, B2, and B3 comprised in second sheet part B, is series connected between the bus bars 16 and 17 via P2 lines 40, 41, and 42, but anti-parallel to the strings of solar cells.

The second string, of bypass diodes, also comprises three series connected bypass diode sub-strings, one comprising bypass diode B1, one comprising bypass diode B2 and one comprising bypass diode B3. Each one of these bypass diode sub-strings could also comprise two or more bypass diodes.

Also similar to the embodiment of Fig. 3, solar cell C1 is separated from bypass diode B1 via P1 and P3 lines in the front electrode layer and the back electrode layer at 43.

Likewise, C1' is separated from B1 at 43', C3 respectively C3' are separated from B2 at 44 respectively 44', and C5 respectively C5' are separated from B3 at 45 respectively 45'.

Similar to the embodiment of Fig. 5, C2 is separated from B1 at 46 by means of a P3 line. Likewise, C2' is separated from B1 at 46'. Likewise, C4 respectively C4' are separated from B2 at 47 respectively 47'.

In order to describe the electrical circuit of Fig. 7b, in conjunction with the structure of Fig. 7a, solar cells C2 and C3 are now considered. As said before, these solar cells are series connected at 36, whereby the back electrode of cell C3 forms the adjacent region to which front electrode of C2 connects. The back electrode of C3 is electrically isolated from any direct connection with bypass diode B1. The front electrode of C3 is in contact with the back electrode of B2 via P2 at 37 and the back electrode of C4 because the back electrode layer extends underneath the P3 line at 47. The front electrode of B2 is in contact with the back electrode of C2 via P2 at 41 and the back electrode of B1, because the back electrode layer extends underneath the P3 line at 46.

In an analogue way the solar cell sub-string that comprises series connected solar cells C2' and C3' are connected in an anti-parallel configuration to the bypass diode sub-string comprising of bypass diode B2.

Summarising the result: the back electrode of solar cell C2 is electrically connected to the front electrode of the bypass diode B2 (via 46 and 41), and the front electrode of the cell C2 makes electrical contact with the back electrode of the bypass diode B2 via the back contact of C2 which thus forms the adjacent region.

This results in the bypass diode sub-string comprising of bypass diode B2 to be anti-parallel to the solar cell sub-string comprising C2-C3 and the solar cell sub-string comprising C2'-C3'. B2 therefore protects two solar cell sub-strings comprising two series connected solar cells. This may of course be extended to solar cell sub-strings comprising three or more series connected cells protected by one bypass diode or one bypass diode sub-string.

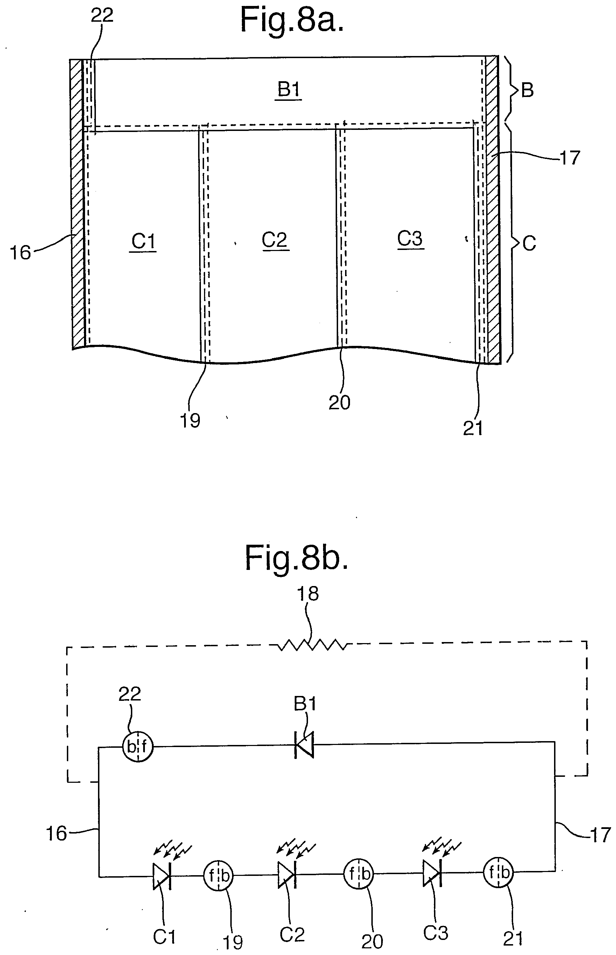

An example of a module wherein all solar cells provided in series between the bus bars are protected by one anti-parallel connected bypass diode is provided in Fig. 8.

In the embodiment of Fig. 8, which is not part of the invention, the rectifying diode sheet is divided in first and second sheet parts C and B via electrical interruptions in the form of P1 and P3 lines. The first sheet part C comprises a first string of three solar cells C1, C2, C3 and electrical series connections 19, 20, 21, and the second sheet part B comprises second string formed of a single bypass diode B1 instead of series connected bypass diodes.

The front electrode of the most upstream electric current generating solar cell C3 is connected to the back electrode of the bypass diode B1 via the electric series connection 21 and the adjacent region associated with bus bar 17. The back electrode of the downstream-most electric current generating solar cell C1 is connected to the front electrode of the bypass diode B1 via bus bar 16 and the electric series connection at 22.

The bypass diode B1 in the embodiment of Fig. 8, may prevent too high of reverse biasing of the solar cells by conducting the current generated by other solar modules that are connected in series with the solar module of Fig. 8, should that one suffer from shading.

A bypass diode circuited anti-parallel to a full series connected string of solar cells between the bus bars may be combined with bypass diodes circuited anti-parallel to a number of solar cells within the string.

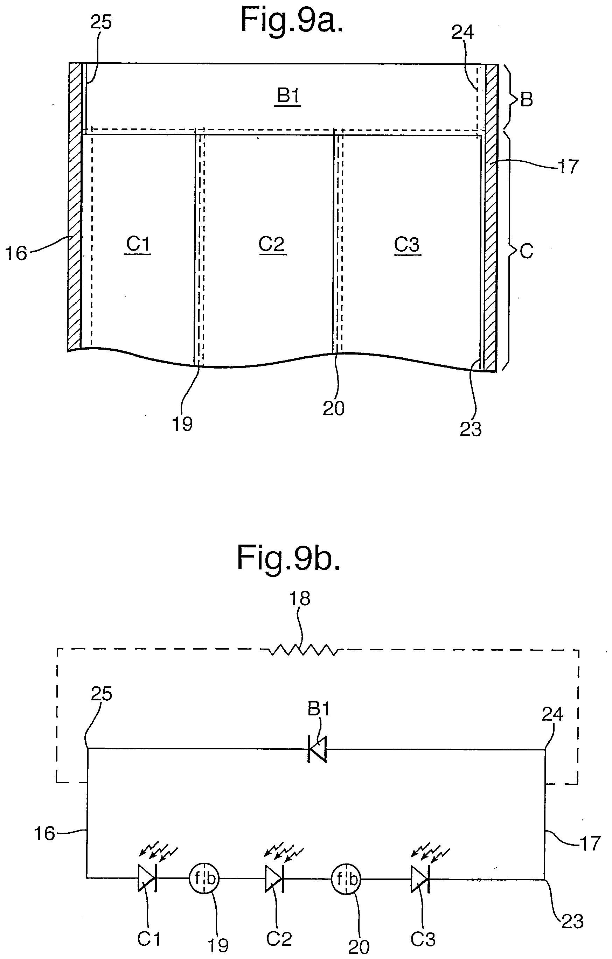

In the embodiments shown and described above, an electrical connection between a front electrode and a bus bar is established by means of a P1-P2-P3 integrated series connection from the front electrode layer to the bus bar via the back electrode layer. It is also possible to connect the bus bar directly to the front electrode layer. An illustrative example is shown in Fig. 9 and forms a close analogue of the embodiment of Fig. 8, but the general principle can be applied to all the embodiments.

Describing the solar module of Fig. 9a in more detail, which is not part of the invention, starting from the bus bar 16 on the left in the first sheet part C, and reading to the right, one encounters: bus bar 16, a P3 line; solar cell C1, the bus bar 16 being connected to the back electrode of solar cell C1 underneath the P3 line, an electrical series connection formed by sequence P1-P2-P3 at 19; solar cell C2; an electrical series connection formed by sequence P1-P2-P3 at 20; and solar cell C3 just like for instance the solar module as shown in Fig. 3a. However, reading further from solar cell C3, a P1 line is encountered at 23 followed by the bus bar 17. Hence, the P1-P2-P3 series connection of Fig. 3a is substituted by a P1 line.

A similar substitution is present where the left hand bus bar 16 connects to the bypass diode B1. Starting from the bus bar 16 on the left in the second sheet part B, and reading to the right, one encounters: bus bar 16, a P1 line at 25; bypass diode B1; P3 line 24; and finally bus bar 17. Of course, a string of series connected bypass diodes may be present instead of just one bypass diode B1.

The P1 line at 23 avoids the back electrode of C3 to short against the back electrode of B1. The P3 line at 24 avoids shorting of the bus bar 17 to the front electrode of bypass diode B1.

The corresponding diode network, as shown in Fig. 9b, is electrically equivalent to the one shown in Fig. 8b. The only difference is structurally at 23 and 24 where direct connections are present between the bus bar 17 and respectively the C3 solar cell cathode and the B1 bypass diode's anode, and at 25 where direct connections are present between the bus bar 16 and the B1 bypass diode's cathode at 25 and C3 solar cell anode, respectively.

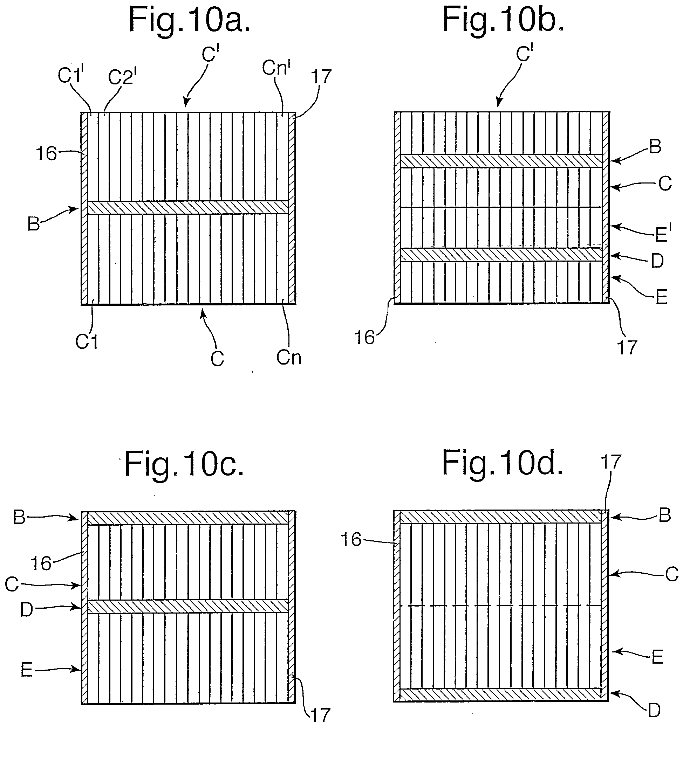

Fig. 10 (parts a to d) shows schematic top views of various general solar module lay outs. Each show left and right hand bus bars 16 and 17.

In Fig. 10a, the rectifying diode sheet is divided in first sheet part C comprising a first set of solar cells C1 to Cn whereby n represents the number of solar cells in the set, second sheet part B comprising a set with at least one bypass diode connected to the bus bars 16, 17 anti-parallel with respect to the solar cells C1 to Cn, and third sheet part C' comprising a second set of solar cells C1', C2' etc. to Cn' connected to the bus bars 16, 17 parallel to the first set of solar cells C1 to Cn. Fig. 10a may be configured as is shown in Fig. 7.

In commercial large area solar modules, n may typically be 10 or higher, such as for example 24.

Of course, the lay out of Fig. 10a may be repeated in a single module such as is exemplified in Fig. 10b. Here bypass diode(s) in the second sheet part B protect solar cells comprised first and third sheet parts C and C', while bypass diode(s) in a fourth sheet part D protect solar cells comprised in fifth and sixth sheet parts E and E'.

In another embodiment, as shown in Fig. 10c, a first set of bypass diode(s) of second sheet part B may protect solar cells of first sheet part C, arranged on one side of the second sheet part B. These may be interrelated such as exemplified in Fig. 3, 4, 5, 6 or 8. Optionally, a third sheet part D comprising a second set of bypass diode(s) 59 may be provided to protect solar cells comprised in a fourth sheet part E of the module. As shown in Fig. 10d, the second set of bypass diode(s), comprised in the third sheet part D, is arranged on the edge of the module relative to the second set of solar cells comprised in the fourth sheet part E that it protects.

In the embodiments shown in Fig. 10, the first sheet parts, comprising the solar cells, covers a larger surface area on the common substrate than the second sheet parts, comprising the bypass diodes. The largest portion of the active thin film area is patterned as solar cells. Only a relatively small fraction of the active area is patterned in reverse polarity to form set or an array of series connected integrated bypass diodes. Thus a relatively small fraction of the available surface area is sacrificed for bypass diodes instead of it being used for electricity generation. Depending on the maximum forward current to be passed through the bypass diodes, the aggregate area of the bypass diodes may consumer between 0.1 and 10 % of the total circuit area.

As the aggregate area of the bypass diodes is small compared to that of the solar cells, the bypass diodes need not be shielded from incident light. However, to limit the efficiency loss of the module, it would be better to shield the bypass diodes from light thereby reducing or eliminating reverse photocurrent during normal operation of the solar module. For instance, an opaque cover may be applied locally over any sheet part comprising bypass diode(s). Such an opaque cover may be placed directly on top of the front electrode of the bypass diodes or may be part of one of additional layers used for encapsulating the solar module, for instance formed of a polymer film and/or a cover glass. The opaque cover may be an electrically conductive one, for instance a metallic one, in order to increase the electrical conductivity of the front electrodes if in direct contact with the front electrodes.

It will be understood that various modifications can be applied on the module lay out without departing from the claimed invention.

Next will be described a method of manufacturing a solar module, again described in terms of substrate technology design to illustrate the basic principles but without intending to be limited to substrate technology design. First a substrate is provided. This may be a translucent substrate, particularly a transparent substrate, such as one made of glass or plastic, or an opaque one such as a metallic one. However, in order to be able to produce an electrical interruption in the back electrode layer and to define separate regions therein, an insulating layer may have to be provided between the substrate and the back electrode layer when the substrate is an electrically conductive one.

Then a back electrode layer with one or more electrical interruptions therein is formed on the substrate. In the case of a solar module to be based of a chalcopyrite material, a molybdenum layer would typically suffice. The layer may be formed using one or more of various available methods of deposition including evaporation, sputter deposition, or chemical or physical vapour deposition.

The electrical interruptions may be formed during the deposition of the back electrode layer, or after the deposition. When after, a groove may for instance be scribed into the layer, or a section of high resistivity material may be written into the back electrode layer. A groove may be formed, for instance by etching, local evaporation, mechanical scribing, or laser scribing. When during applying the back electrode layer, an area may for instance be masked at localities where an electrical interruption is desired to be formed, to there locally avoid application of the back electrode layer.

Next, an absorber layer may be formed, with one or electrical interruptions in the form of holes extending through the absorber layer at predetermined locations relative to the one or more electrical interruptions formed in the back electrode layer. The back electrode layer is thereby locally exposed. There are many possible types of absorber layer, and it will be available to the skilled person in standard literature how to form the absorber layer of choice.

As with the back electrode layer, the electrical interruptions in the absorber layer may be formed after application of the layer or during.

Next, a front electrode layer is formed on the absorber layer, with one or more electrical interruptions at predetermined locations relative to the one or more electrical interruptions formed in the back electrode layer. As with the back electrode layer, the electrical interruptions in the absorber layer may be formed after application of the layer or during.

Integrated electric series connections may be created between the back electrode layer and the front electrode layer, for instance by allowing the material from the front electrode layer to fill the holes provided in the absorber layer that exposed the back contact layer.

The order of forming the front electrode layer and the back electrode layer may be reversed, such that the front electrode layer first formed and the back electrode layer is formed after the absorber layer has been formed. In that case, the holes in the absorber layer expose the front electrode layer and the integrated electric series connections may be created by allowing the material from the back electrode layer to fill the holes provided in the absorber layer.

In either case, where the absorber layer comprises a chalcopyrite absorber layer, ZnO may be selected as the front electrode layer. Optionally there may applied an additional layer of a II-VI material prior to forming the front contact layer, such as CdS.

Optionally, one or more encapsulation layers, such as polymer encapsulation layers and cover plates formed of for instance glass or plastic, may be provided for enhancing environmental and/or mechanical durability.

It will be apparent that, independently from the bus bars and the electrical connections of the strings of solar cells and bypass diodes to the bus bars, the solar modules disclosed and described hereinbefore have other advantageous features which may be claimed independently or in combination.

The invention provides a solar module for connecting to an electric load, the solar module comprising a common substrate supporting a rectifying diode sheet, the rectifying diode sheet comprising at least a back electrode layer, a front electrode layer, and an absorber layer located between the back electrode layer and the front electrode layer, whereby the back electrode layer has a higher electrical conductivity than the front electrode layer, wherein the rectifying diode sheet is divided in first and second sheet parts, said first sheet part comprising at least one solar cell having front and back electrodes formed in the front and back electrode layers, and an integrated electric series connection between the solar cell's front electrode and an adjacent region, defined in the back electrode layer, that is electrically separated from the solar cell's back electrode, and whereby the second sheet part comprises at least one bypass diode having front and back electrodes formed in the front and back electrode layers, the bypass diode being circuited in an anti- parallel configuration with the at least one solar cell, whereby the back electrode of the solar cell is electrically connected to the front electrode of the bypass diode and the front electrode of the solar cell makes electrical contact with the back electrode of the bypass diode via at least the adjacent region of the back electrode layer, and whereby the solar module is connectable to the electric load via at least the back electrode of the solar cell and at least the adjacent region of the back electrode layer.

Since the front electrode of the solar cell makes electrical contact with the back electrode of the bypass diode via at least the adjacent region defined in the back electrode layer, the electric connection to the bypass diode does not, or to a lesser extent, require conduction through the front electrode layer. The connection of the solar cell with the bypass diode can thus benefit from the higher electrical conductivity of the back electrode layer compared to that of the front electrode layer.

This may cause less overheating of the solar cell and/or more effectively limit the maximum reverse bias voltage a solar cell may be exposed to, when during the generation of electric current the bypass diode needs to be conducting some of the current due to shading of the module or parts thereof.

Generally, the rectifying diode sheet may be divided in first and second sheet parts by means of one or more electrical interruptions formed in one or more of the front electrode layer, the back electrode layer, and the absorber layer. More specifically, in preferred embodiments the rectifying diode sheet may be divided in said first and second sheet parts by means of an electrical interruption in at least the front electrode layer.

According to the invention, parts of the back electrode layer between the first and second sheet parts are continuous with no interruption. There is no interruption in the back electrode layer between the first and second sheet parts. Herewith it is achieved that the one or more solar cells defined in the first sheet part can be connected to the one or more bypass diodes defined in the second sheet part with the least electrical resistance because the full back electrode layer is available for establishing electric contact between the two sheet parts.

The adjacent region defined in the back electrode layer may form part of the bus bar, or, the adjacent region may form part of the back electrode layer of a neighbouring solar cell.

Regarding the first sheet part comprising first and second solar cells, the back electrode of the second solar cell comprises the adjacent region to which the first solar cell's front electrode is connected via the integrated electric series connection. Said integrated series connection may form a first integrated series connection, and said adjacent region may form a first adjacent region. The first sheet part in said embodiments may further comprise a second integrated electric series connection between the second solar cell's front electrode and a second adjacent region defined in the back electrode layer that is electrically separated from the second solar cell's back electrode. This second adjacent region may form part of a bus bar or of a third solar cell.

More solar cells may be added in a similar fashion. According to the invention, at least part of the bypass diode lies side by side with respect to the adjacent region of the back electrode layer. In the context of the present specification, side-by-side means that at least a part of one side of the adjacent region faces at least a part of one side of the bypass diode. Preferably, at least 10 %, more preferably at least 50 %, of a side length of the adjacent region or the bypass diode is side-by-side to respectively the bypass diode and the adjacent region.

Since the portion that is side-by-side can be available for electrically connecting the bypass diodes with the solar cells, the electrical resistance between the adjacent region and the back electrode of the bypass diode can be smaller if a large fraction of the side lengths are arranged side-by-side.

This is illustrated in Fig. 3a where e.g. the part of bypass diode B1 at 28 lies side-by-side against solar cell C2. In Figs. 5a and 6 the entire bypass diode B1 lies side-by-side to solar cell C2, and the bypass diode B3 lies side-by-side to the bus bar 17 or the area adjacent to the bus bar 17 in Fig. 7, approximately half of e.g. bypass diode B2 lies side-by-side to solar cells C4 and C4'.

When arranged side-by-side, the adjacent region of the back electrode layer and the back electrode layer of the bypass diode advantageously are formed in the back electrode layer by maintaining an unpatterned section in the back electrode layer wherein the back electrode layer has not been patterned or interrupted. In such a section, the back electrode layer continues uninterrupted from the first sheet part into the second sheet part.

Thus, the adjacent region of the back electrode layer suitably continues underneath the electrical interruption (e.g. a P3 line) in the front electrode layer that divides first and second sheet parts into the back electrode layer of the bypass diode.

In the case that the adjacent region of the back electrode layer forms part of the back electrode layer of a neighbouring solar cell, the adjacent region of the back electrode layer is preferably formed by the full back electrode layer of the neighbouring solar cell.

The at least one solar cell may cover an area on the common substrate which area has an elongated shape having a long side and a short side that is shorter than the long side, whereby the electrical series connection is located along the long side. Herewith, the adjacent region of the back electrode layer may be conveniently comprised in the first sheet part and located adjacent to the long side. The second sheet part may suitably be located adjacent to the short side.

If the adjacent region of the back electrode layer is a back electrode layer of a neighbouring solar cell also having an elongated shape, the majority of the neighbouring solar cell's short side can be side-by-side to the bypass diode, so that the back electrode of the neighbouring solar cell can be connected to the back electrode of the bypass diode over the majority of the short side.

Preferably, substantially the entire short side is side-by-side relative to the bypass diode, such as is shown in e.g. Figs. 5a and 6, where the back electrode of e.g. solar cell C2 is connected with the back electrode of bypass diode B1 along substantially the entire short side of solar cell C2 under line 33. Likewise, in Fig. 7a the back electrode of e.g. solar cell C2 is connected with the back electrode of bypass diode B1 under line 46. This minimises the electrical resistance between the back electrode of the solar cells and the bypass diodes.

Of course, in any of these embodiments, the front electrode layer of the second sheet part may be at least partly covered with a shield layer of an opaque material, as described above, whereby the opaque material may optionally have a higher conductivity than the front electrode layer.

While the illustrative embodiments have hereinbefore been described with particularity, it will be understood that various other modifications will be readily apparent to, and can be easily made by one skilled in the art.

For instance, embodiments of the invention also cover other possible variations of design including other locations on the solar module of the sheet parts comprising the bypass diode(s), set comprising a smaller or larger number of solar cells and bypass diodes, as well as a plurality of solar cells being bridged per single bypass diode in anti-parallel arrangement.

For instance, the P2 or P3 lines may be optionally coated with an insulating material to avoid shorting. This may be particularly important on the P3 lines that separate the front electrodes of the solar cells and bypass diodes from the bus bars 16 or 17.

The invention is also applicable to tandem cells wherein two or more rectifying sheets are stacked on top of each other.

The terms "front electrode" and "front electrode layer" are intended to refer to electrode and electrode layer on the light-receiving side of the solar cell.

The term substrate is intended to be construed such to also include a "superstrate" and the claims are intended to include so-called superstrate technology wherein the front electrode layer, which as stated before defines the light-receiving side of the solar module, is closer to the substrate than the back electrode layer so that the substrate is located on the light-receiving side of the solar module.

The term absorber layer as used herein is employed as any type of semiconductor layer capable of absorbing light and thereby creating electron-hole pairs.

The present invention is applicable to all thin film solar cells comprising a thin-film diode structure, including those based on the following non-exhaustive list of silicon-based thin film, chalcopyrite compounds, II-VI compounds and analogues, III-V compounds and analogues, organic materials, and dye-sensitized solar cells.

The term silicon is herein employed as a genus term that covers at least the following species: amorphous silicon, microcrystallinesilicon, polycrystalline silicon. Other elements may be present, such as germanium and hydrogen, or for instance, doping elements and trace elements.

The term chalcopyrite compound is herein employed as a genus term that covers materials formed of a group I-III-VI₂ semiconductor or a group II-IV-V₂ semiconductor, including a p-type semiconductor of the copper indium diselenide ("CIS") type. Special cases are sometimes also denoted as CIGS or CIGSS. It covers at least the following species: CuInSe2; CuInₓGa₍₁₋ₓ₎Se₂; CuIn_{xGa(1-x)} Se_{y}S_{(2-y)}; CuInₓGa_{z}Al_{(1-x-z)}Se_{y}S_{(2-y)}, and combinations thereof; wherein 0 ≤ x ≤ 1; 0 ≤ x+z ≤ 1; and 0 ≤ y ≤ 2. The chalcopyrite compound may further comprise a low concentration, trace, or a doping concentration of one or more further elements or compounds, in particular alkali such as sodium, potassium, rubidium, caesium, and/or francium, or alkali compounds. The concentration of such further constituents is typically 5 wt% or less, preferably 3 wt% or less.

The term II-VI compounds is herein employed as a genus term that covers compounds wherein any number of group II elements from the periodic system and any number of group VI elements from the periodic system are present. Amongst examples are ZnSe, ZnS, ZnSₓSe₁₋ₓ, ZnSₓ(OH)₁₋ₓ, CdS, CdSe, CdTe. Other elements may be present in such compounds, such as for instance doping elements and trace elements.

The term III-V compounds is herein employed as a genus term that covers compounds wherein any number of group III elements from the periodic system and any number of group V elements from the periodic system are present. Amongst examples are GaAs, AlₓGa₁₋ₓAs, InₓGa₁₋ₓAs, GaP, InₓGa₁₋ₓP, InₓGa₁₋ₓAs_{z}P_{1-z} (wherein 0 ≤ z ≤ 1). Other elements may be present, such as for instance doping elements and trace elements. The term absorber layer is intended to cover multilayers, and moreover other layers may be located between the back electrode layer and the front electrode layer in addition to the absorber layer. As an example, in the case of a chalcopyrite absorber layer, a layer of a II-VI compound such as for example CdS may be present.

The front electrode is suitably made of a transparent conductive material. Transparent conductive oxides have proven to be of particular suitability in various types of solar cells. Amongst common transparent conductive oxides are zinc-oxide (ZnO), indium-tin-oxide (ITO).

The back electrode is suitably made of a highly conductive metal. Of specific importance are considered copper, aluminium, molybdenum, tungsten, and silver.

## Claims

1. A solar module comprising first and second bus bars and a common substrate supporting a rectifying diode sheet, the rectifying diode sheet comprising at least a back electrode layer, a front electrode layer, and an absorber layer located between the back electrode layer and the front electrode layer, wherein the rectifying diode sheet is divided in first and second sheet parts, said first sheet part comprising a first string of one or more series connected solar cells each having front and back electrodes formed in the front and back electrode layers, which first string is series connected to the first and second bus bars, and said second sheet part comprising a second string of one or more series connected bypass diodes each having front and back electrodes formed in the front and back electrode layers, which second string is connected in an anti-parallel configuration with the first string via the first and second bus bars, wherein the back electrode layer has a higher electrical conductivity than the front electrode layer, and wherein the first string comprises a first solar cell sub-string and a second solar cell sub-string, and the second string comprises a first bypass diode sub-string and a second bypass diode sub-string, wherein the first solar cell sub-string comprises one or more solar cells, and the second solar cell sub-string comprises one or more solar cells, whereby the first and second solar cell sub-strings are series connected, and wherein the first bypass diode sub-string comprises one or more bypass diodes and the second bypass diode sub-string comprises one or more bypass diodes, whereby the first bypass diode and second bypass diode sub-strings are directly series connected, wherein the first and second solar cell sub-strings and the first and second bypass diode sub-strings are each series connected with an integrated electric series connection, whereby in addition to the first string and second string being connected in anti-parallel configuration via the first and second bus bars, the first solar cell sub-string is connected in anti-parallel configuration with the first bypass diode sub-string and the second solar cell sub-string is connected in anti-parallel configuration with the second bypass diode sub-string, and wherein the front electrode of the one solar cell in the first solar cell sub-string that is series connected to the back electrode of the one solar cell in the second solar cell sub-string is also connected to the back electrode of the one bypass diode in the first bypass diode sub-string that is series connected with the front electrode of the one bypass diode in the second bypass diode sub-string, wherein the back electrode layer extends from the back electrode of the one solar cell in the second solar cell sub-string to the back electrode of the one bypass diode in the first bypass diode sub-string, and wherein at least a part of the one bypass diode in the first bypass diode sub-string faces at least a part of the one solar cell in the second solar cell sub-string [page 34, last paragraph, to page 35, first paragraph, of WO-publication, Fig. 3A].

2. The solar module of claim 1, wherein the first and second bus bars each have a higher electrical conductivity than the front electrode layer.

3. The solar module of claim 1 or 2, which is connected to an electric load via the first and second bus bars to allow the first string to generate an electric current.

4. The solar module of any of the previous claims, wherein the rectifying diode sheet is divided in said first and second sheet parts by means of one or more electrical interruptions formed in one or more of the front electrode layer, the back electrode layer, and the absorber layer.

5. The solar module of claim 1, wherein the integrated electric series connection comprises an electrical interruption formed in the front electrode layer, an electrical interruption formed in the back electrode layer, and an opening provided in the absorber layer, whereby a conductive material is in contact with the front electrode layer and the back electrode layer which passes through the opening provided in the absorber layer.

6. The solar module of any one of the previous claims, wherein the first sheet part covers a larger surface area on the common substrate than the second sheet part.

7. The solar module of one of the previous claims, wherein the second sheet part is at least partly covered with a shield layer of an opaque material.

8. The solar module of claim 7, wherein the opaque material has a higher conductivity than the front electrode layer.

9. The solar module of any one of the previous claims, wherein the rectifying diode sheet comprise a thin-film diode structure.

## Patentansprüche

1. Solarmodul mit einer ersten Busbar und einer zweiten Busbar und einem gemeinsamen Substrat, das eine gleichrichtende Diodenschicht stützt, wobei die gleichrichtende Diodenschicht wenigstens eine Rückelektrodenschicht, eine Frontelektrodenschicht, und eine Absorberschicht, die zwischen der Rückelekrodenschicht und der Frontelektrodenschicht angeordnet ist, umfasst, wobei die gleichrichtende Diodenschicht in einen ersten Schichtabschnitt und einen zweiten Schichtabschnitt unterteilt ist, wobei der erste Schichtabschnitt einen ersten Strang aus einer oder mehreren serienverschalteten Solarzellen, die jeweils eine in der Front- und Rückelektrodenschicht geformte Front- und Rückelektrode aufweisen, umfasst, wobei der erste Strang serienverschaltet ist mit der ersten und zweiten Busbar, und wobei der zweite Schichtabschnitt einen zweiten Strang aus einer oder mehreren serienverschalteten Bypassdioden, von denen jede in der Front- und Rückelektrodenschicht geformte Front- und Rückelektrode aufweist, umfasst, wobei der zweite Strang über die erste und zweite Busbar in einer anti-parallelen Konfiguration mit dem ersten Strang verbunden ist, wobei die Rückelektrodenschicht eine höhere elektrische Leitfähigkeit als die Frontelektrodenschicht hat, und wobei der erste Strang einen ersten Solarzell-Unterstrang und einen zweiten Solarzell-Unterstrang aufweist und der zweite Strang einen ersten Bypassdiode-Unterstrang und einen zweiten Bypassdiode-Unterstrang aufweist, wobei der erste Solarzell-Unterstrang eine oder mehrere Solarzellen aufweist, und der zweite Solarzell-Unterstrang eine oder mehrere Solarzellen aufweist, wobei der erste und zweite Solarzell-Unterstrang serienverschaltet sind, und wobei der erste Bypassdiode-Unterstrang eine oder mehrere Bypassdioden aufweist und der zweite Bypassdiode-Unterstrang eine oder mehrere Bypassdioden aufweist, wobei der erste und zweite Bypassdiode-Unterstrang direkt serienverschaltet sind, wobei der erste Solarzell-Unterstrang und der zweite Solarzell-Unterstrang und der erste Bypassdiode-Unterstrang und der zweite Bypassdiode-Unterstrang jeweils mit einer integrierten elektrischen Serienverschaltung serienverschaltet sind, wobei zusätzlich zu dem ersten Strang und zweiten Strang, die über die erste und zweite Busbar in anti-paralleler Konfiguration verbunden sind, der erste Solarzell-Substrang in anti-paralleler Konfiguration mit dem ersten Bypassdiode-Substrang und der zweite Solarzell-Substrang in anti-paralleler Konfiguration mit dem zweiten Bypassdiode-Substrang verbunden ist, und wobei die Frontelektrode der einen Solarzelle im ersten Solarzell-Substrang, die mit der Rückelektrode der einen Solarzelle im zweiten Solarzell-Substrang serienverschaltet ist, auch verbunden ist mit der Rückelektrode der einen Bypassdiode im ersten Bypassdioden-Substrang, welche serienverschaltet ist mit der Frontelektode der einen Bypassdiode im zweiten Bypassdioden-Substrang, wobei sich die Rückelektrodenschicht von der Rückelektrode der einen Solarzelle im zweiten Solarzell-Substrang zur Rückelektrode der einen Bypassdiode im ersten Bypassdiode-Substrang erstreckt, und wobei wenigens ein Teil der einen Bypassdiode im ersten Bypassdiode-Substrang wenigstens einem Teil der einen Solarzelle im zweiten Solarzell-Substrang gegenüberliegt.

2. Solarmodul nach Anspruch 1, bei welchem die erste Busbar und die zweite Busbar jeweils eine höhere elektische Leitfähigkeit haben als die Frontelektrodenschicht.

3. Solarmodul nach Anspruch 1 oder 2, welches über die erste Busbar und die zweite Busbar mit einer elektrischen Last verbunden ist, um es dem ersten Strang zu ermöglichen, einen elektrischen Strom zu erzeugen.

4. Solarmodul nach einem der vorhergehenden Ansprüche, bei welchem die gleichrichtende Diodenschicht mittels einer oder mehrerer elektrischer Unterbrechungen, die in einer oder mehreren Schichten aus der Frontelektrodenschicht, der Rückelektrodenschicht und der Absorberschicht geformt sind, in den ersten und zweiten Schichtabschnitt unterteilt ist.

5. Solarmodul nach Anspruch 1, bei welchem die integrierte Serienvrschaltung eine in der Frontelektrodenschicht geformte elektrische Unterbrechung, eine in der Rückelektrodenschicht geformte elektrische Unterbrechung, und eine in der Absorberschicht bereitgestellte Öffnung umfasst, wobei ein leitfähiges Material in Kontakt ist mit der Frontelektrodenschicht und der Rückelektrodenschicht, welches die in der Absorberschicht bereitgestellte Öffnung passiert.

6. Solarmodul nach einem der vorhergehenden Anspüche, wobei der erste Schichtabschnitt einen größeren Oberflächenbereich auf dem gemeinsamen Substrat als der zweite Schichtabschnitt überdeckt.

7. Solarmodul nach einem der vorhergehenden Ansprüche, wobei der zweite Schichtabschnitt wenigstens teilweise mit einer Deckschicht aus einem opaken Material bedeckt ist.

8. Solarmodul nach Anspruch 7, bei welchem das opake Material eine höhere Leitfähigkeit hat als die Frontelektrodenschicht.

9. Solarmodul nach einem der vorhergehenden Ansprüche, wobei die gleichrichtende Diodenschicht eine Dünnschicht-Diodenstruktur aufweist.

## Revendications

1. Un module solaire comprenant une première et une deuxième barre omnibus et un substrat commun soutenant une feuille de diodes de redressement, la feuille de diodes de redressement comprenant au moins une couche d'électrode arrière, une couche d'électrode avant et une couche absorbante située entre la couche d'électrode arrière et la couche d'électrode avant, où la feuille de diodes de redressement est divisée en une première et une deuxième partie, ladite première partie de la feuille comprenant une première série d'une ou plusieurs cellules solaires connectées en série dont chacune a une électrode avant et arrière formées dans la couche d'électrode avant et arrière, où ladite première série est connectée en série à la première et la deuxième barre omnibus et ladite deuxième partie de la feuille comprend une deuxième série d'une ou plusieurs cellules solaires connectées en série, dont chacune a une électrode avant et arrière formées dans la couche d'électrode avant et arrière, ladite deuxième série étant reliée en configuration antiparallèle à la première série par la première et la deuxième barre omnibus, où la couche d'électrode arrière a une conductivité électrique supérieure à celle de la couche d'électrode avant, et où la première série comprend une première sous-série de cellules solaires et une deuxième sous-série de cellules solaires, et la deuxième série comprend une première sous-série de diodes de dérivation et une deuxième sous-série de diodes de dérivation, où la première sous-série de cellules solaires comprend une ou plusieurs cellules solaires et la deuxième sous-série de cellules solaires comprend une ou plusieurs cellules solaires, où la première et la deuxième sous-série de cellules solaires sont connectées en série, et où la première sous-série de diodes de dérivation comprend une ou plusieurs diodes de dérivation et la deuxième sous-série de diodes de dérivation comprend une ou plusieurs diodes de dérivation, où la première sous-série de diodes de dérivation et la deuxième sous-série de diodes de dérivation sont connectées directement en série, où la première et la deuxième sous-série de cellules solaires et la première et la deuxième sous-série de diodes de dérivation sont connectées en série respectivement avec une connexion en série électrique intégrée, où outre la connexion en série de la première et la deuxième série en configuration antiparallèle par la première et la deuxième barre omnibus, la première sous-série de cellules solaires est connectée en configuration antiparallèle à la première sous-série de diodes de dérivation et la deuxième sous-série de cellules solaires est connectée en configuration antiparallèle à la deuxième sous-série de diodes de dérivation et où l'électrode avant de la seule cellule solaire dans la première sous-série de cellules solaires qui est connectée en série à l'électrode arrière de la seule cellule solaire dans la deuxième sous-série de cellules solaires est également connectée à l'électrode arrière de la seule diode de dérivation dans la première sous-série de diodes de dérivation qui est connectée en série à l'électrode avant de la seule diode de dérivation dans la deuxième sous-série de diodes de dérivation, et où la couche d'électrode arrière s'étend de l'électrode arrière de la seule cellule solaire dans la deuxième sous-série de cellules solaires à l'électrode arrière de la seule diode de dérivation dans la première sous-série de diodes de dérivation, et où au moins une partie de la seule diode de dérivation dans la première sous-série de diodes de dérivation se trouve en face d'au moins une partie de la seule cellule solaire dans la deuxième sous-série de cellules solaires [page 34 dernier paragraphe à page 35, premier paragraphe, de la publication-WO, Fig. 3A].

2. Le module solaire de la revendication 1, où la première et la deuxième barre omnibus possèdent chacune une conductivité électrique supérieure à celle de la couche d'électrode avant.

3. Le module solaire selon la revendication 1 ou 2, qui est relié à une charge électrique par la première et la deuxième barre omnibus pour permettre à la première série de générer un courant électrique.

4. Le module solaire selon l'une quelconque des revendications précédentes, où la feuille de diodes de redressement est divisée en ladite première et ladite deuxième partie de la feuille par le biais d'une ou plusieurs interruptions électriques formées dans une ou plusieurs parmi la couche d'électrode avant, la couche d'électrode arrière et la couche absorbante.

5. Le module solaire selon la revendication 1, où la connexion en série électrique, intégrée comprend une interruption électrique formée dans la couche de l'électrode avant une interruption électrique formée dans la couche d'électrode arrière et une ouverture prévue dans la couche absorbante, où un matériau conducteur est en contact avec la couche d'électrode avant et la couche d'électrode arrière qui passe à travers l'ouverture prévue dans la couche absorbante.

6. Le module solaire selon l'une des revendications précédentes, où la première partie de la feuille occupe une plus grande surface du substrat commun que la deuxième partie de la feuille.

7. Le module solaire selon l'une des revendications précédentes, où la deuxième partie de la feuille est au moins partiellement recouverte d'une couche de blindage d'un matériau opaque.

8. Le module solaire selon la revendication 7, où le matériau opaque possède une conductivité supérieure à celle de la couche d'électrode avant.

9. Le module solaire selon l'une quelconque des revendications précédentes, où la feuille de diodes de redressement comprend une structure de diodes à film mince.
